# EUROPEAN PATENT SPECIFICATION

(11) **EP 0 324 198 B1**
(45) Date of publication and mention of the grant of the patent: **16.03.1994**
(21) Application number: 88202709.7
(22) Date of filing: 28.11.1988
(51) Int. Cl.: H01L 21/60, H01L 21/90

(54) **Manufacturing method for electrical connections in integrated circuits**
Verfahren zum Herstellen von elektrischen Kontakten in integrierten Schaltungen
Procédé de fabrication de contacts dans des circuits intégrés

(30) Priority: 02.12.1987 GB 8728142
(43) Date of publication of application: 19.07.1989
(73) Proprietor: Philips Electronics N.V., 5621 BA Eindhoven (NL)
(72) Inventor: De Werdt, Reinier C/O PHILIPS INTERNATIONAL B.V., NL-5656 AA Eindhoven (NL); De Bruin, Leendert C/O PHILIPS INTERNATIONAL B.V., NL-5656 AA Eindhoven (NL)
(74) Representative: Stevens, Brian Thomas

(56) References cited:
- EP-A- 0 200 082
- EP-A- 0 234 407
- EP-A- 0 239 489
- US-A- 4 624 864
- JOURNAL OF THE ELECTROCHEMICAL SOCIETY, vol. 131, no. 1, January 1984, pages 123-125, Manchester, New Hampshire, US; E.R. SIRKIN et al.: "A method of forming contacts between two conducting layers separated by a dielectric"

## Description

This invention relates to methods of fabricating electrical connections to a substructure forming part of an integrated circuit, particularly but not exclusively a semiconductor integrated circuit of the VLSI (very large scale integration) type having contact and via openings and/or conductor tracks with widths of about 1µm (micrometre) or less.

Various types of method are known for patterning layers of electrically insulating and conductive materials to fabricate electrical connections to such a substructure. Published European patent applications EP-A-0 200 082, EP-A-0 239 489, and EP-A-0 234 407 disclose examples of three different types, of which EP-A-0 200 082 involves a lift-off of overlying conductive material, EP-A-0 239 489 involves an etch-back of an insulating layer overlying a conductor pattern, and EP-0 234 407 involves an etch-back of a conductive layer overlying an insulating layer pattern.

In the method of the lift-off type as described in EP-A-0 200 082, a high-temperature polyimide layer is applied to a first polyimide layer; these two layers are etched through a photoresist mask to form via openings in the insulating first polyimide layer; after depositing a metal conductive layer, the high-temperature polyimide layer is lifted off the first polyimide layer so as to lift away the overlying part of the metal conductive layer. The lift-off is effected with a solvent, and it is said in EP-A-0 200 082 that such solvents cause less damage to the underlying substructure than etch processes would do. The metal conductive layer has a smaller thickness than the combined thicknesses of the two polyimide layers and is discontinuous at the openings in the high-temperature polyimide layer so as to permit the solvent to penetrate the edge of the high-temperature polyimide layer at the openings.

In the method involving etch-back of an insulating layer as described in EP-A-0 239 489, the conductor pattern constituting the electrical connections is first formed on the substructure before depositing a thick insulating layer; the thick insulating layer is then deposited over the substructure and covers the conductor pattern, and this insulating layer is then etched back to expose the tops of the conductor pattern and thereby also to form the connection openings in the insulating layer.

The present invention relates to a method of the type involving etch-back of the conductive material, which includes the steps of: (a) forming at a surface of the substructure an electrically insulating layer having openings for the electrical connections, (b) depositing at least first electrically conductive material over the upper surface of the insulating layer and in the openings, the deposition being effected to a thickness sufficient to fill the openings and sufficient to provide for the first conductive material a largely planar upper surface which extends over both the insulating layer and the openings therein, (c) subjecting the planar upper surface to an etching treatment to etch back the first conductive material through a thickness sufficient to remove the first conductive material from over the upper surface of the insulating layer while leaving the first conductive material in the openings, and (d) thereafter depositing a second electrically conductive material over the first conductive material and the upper surface of the insulating layer to provide together with the first conductive material in the openings at least part of the electrical connections to the substructure.

Three specific forms of such a method are described in published European patent application EP-A-0 234 407, United States patent specification US-A-4 624 864 and the paper "The contact properties to titanium silicide and the adhesion within sub-micron contact holes of etched-back CVD tungsten adhesion layer films "by R.C. Ellwanger et al, pages 385 to 394 of the book "Tungsten and other refractory metals for VLSI applications II", Proceedings of the 1986 Workshop held November 12-14, 1986, Palo Alto, California, USA, published by the Materials Research Society, Pittsburgh, Pennsylvania, USA.

In the form disclosed in the 1986 Workshop paper, a contact layer of for example TiSi₂ is first formed at the silicon surface areas exposed at openings in an oxide insulating layer, after which tungsten is deposited in accordance with step (b) using for example a Genus 8402 chemical vapour deposition (CVD) reactor. The tungsten was deposited in a two-step process by first growing a thickness of 0.4µm using WF₆, SiH₄ and H₂ and then continuing to its final thickness with WF₆ and H₂ alone. The tungsten is then etched back in accordance with step (c) using for example an Electrotech 600 plasma etch system with SF₆. As a result, a plug of tungsten is left in the contact opening substantially co-planar with the oxide layer surface.

In the specific form described in US-A-4 624 864 with reference to Figures 3,4,5,6,9 and 10, a barrier layer of tungsten or titanium-tungsten alloy is first formed on the insulating layer and in the contact openings. Over this layer which is termed "the first conductive layer" in US-A-4 624 864, polycrystalline silicon is deposited to a thickness sufficient to form a largely planar upper surface as in step (b) above. Thereafter the polycrystalline silicon is etched back using, for example, SF₆ to leave a polycrystalline silicon plug in the contact openings. In this etching treatment the thin tungsten or titanium-tungsten layer acts as an etch-stop where it extends on the insulating layer.

An alternative form using a sacrificial planarizing layer is also described in US-A-4 624 864 with reference to Fgures 3 to 5, and 7 to 10. In this method a planarizing layer of for example photoresist is coated over the thick polycrystalline silicon to form an even flatter upper surface before etching back with an etching treatment using for example SF₆ and O₂ to etch away the whole photoresist planarizing layer and the polycrystalline silicon over the insulating layer. Once again, the thin titanium or/and tungsten layer acts as an etch stop to prevent etching of the insulating layer.

The use of such a sacrificial planarizing layer is also disclosed in EP-A-0 234 407, for forming plugs of for example molybdenum or tungsten. The molybdenum or tungsten is shown deposited to a thickness sufficiently large as to fill completely the openings in the insulating layer, and the plug formed by etch-back almost completely fills the opening. However it is also contemplated in EP-A-0 234 407 that partial filling is capable of providing an adequate plug for the interconnection.

In work leading to the present invention the present applicants have examined the etch-back process for a conductive overlayer, and in particular the etch-back of tungsten to produce a tungsten plug which is adequately coplanar with the upper surface of the insulating layer. This further work by the applicants has shown that, especially when the process is implemented in a volume-manufacturing situation, a sufficient deterioration in coplanarity can result from various processing inhomogeneities as to cause step coverage problems for the next layer or layers which is or are deposited over the plug material in the openings and over the upper surface of the insulating layer.

The present invention is based on a recognition of the nature of these problems and on a recognition that they can be mitigated in a simple manner even in a volume-manufacturing situation by etching the insulating layer to produce a lower surface after etching away the first conductive material to leave the plug material in the openings and before depositing the second material to form the next layer.

Thus, according to a first aspect of the invention there is provided a method of fabricating electrical connections to a substructure forming part of an integrated circuit, for example a VLSI semiconductor integrated circuit, including the steps of:
(a) forming at a surface of the substructure an electrically insulating layer having openings for the electrical connections, (b) depositing at least first electrically conductive material over the upper surface of the insulating layer and in the openings, the deposition being effected to a thickness sufficient to fill the openings and sufficient to provide for the first conductive material a largely planar upper surface which extends over both the insulating layer and the openings therein, (c) subjecting the planar upper surface to an etching treatment to etch back the first conductive material through a thickness sufficient to remove the first conductive material from over the upper surface of the insulating layer while leaving the first conductive material in the openings, and (d) thereafter depositing a second electrically conductive material over the first conductive material and the upper surface of the insulating layer to provide together with the first conductive material in the openings at least part of the electrical connections to the substructure, the method being characterised in that the insulating layer is formed in step (a) to a thickness larger than desired for the final structure, and in that after etching back the first conductive material in step (c) and before depositing the second conductive material in step (d), there is performed at least a step of: (e) subjecting the upper surface of the insulating layer to an etching treatment which etches the insulating layer at a rate faster than the first conductive material so as to form a new upper surface of the insulating layer at a level which is lower than or substantially the same as the upper surfaces of the first conductive material in the openings in the insulating layer.

According to a second aspect of the invention, there is provided a method of manufacturing an integrated circuit (for example a VLSI semiconductor circuit) wherein, after fabricating a substructure to form part of the device, electrical connections are fabricated to the substructure using a method in accordance with the first aspect of the invention.

According to a third aspect of the invention, there is provided an integrated circuit manufactured using a method in accordance with the first and/or second aspects of the invention.

Thus, the applicants have found that, due to various processing inhomogeneities, a significant part of the first conductive material may be removed from the upper parts of at least some of the openings in etching step (c) so that a step-down occurs at the edges of those openings. By etching the insulating layer in step (e), a new upper surface is formed at a level lower than or substantially the same as the upper surfaces of the conductive material in the openings so that either a step-up or substantially no step occurs at the edges of the openings. The applicants have found that, in the deposition of the material for the next conductive layer over these edges, there is much less of a coverage problem over the step-ups than over large step-downs. The formation of the new upper surface of the insulating layer in step (e) may also provide an improvement in the quality of the insulator interface in the integrated circuit interconnection system. These advantages may be achieved without needing to provide a sacrificial planarizing layer.

However, a sacrificial planarizing layer may be used with advantage in a method in accordance with the invention. Thus, a sacrificial planarizing layer may be provided to obtain a smoother, flatter surface for the insulating layer when using an etching treatment in step (e) which would otherwise produce a rough new surface. Furthermore, under some circumstances with sloping walls of the openings and depending on how anisotropic is the etching treatment of step (e), the insulating layer may be etched deeper at the exposed edges of the openings and this may result in narrow crevices being formed in the insulating layer beside the first conductive material in the openings. Crevices may also be formed by the etching of an adhesion layer exposed at the walls of the openings. The provision of a sacrificial planarizing layer for the etch-back of the insulating layer may be used to overcome or to reduce such problems which might otherwise occur. Thus, a method in accordance with the invention may be further characterised by performing between steps (c) and (e) at least a step of depositing a further material over the upper surface of the insulating layer and over the first conductive layer in the openings to a thickness sufficient to form a largely planar upper surface of the further material, which further material is removed in step (e). For a particularly simple situation the material and to the etching treatment of step (e) are preferably chosen such that this further material etches away at a rate which is substantially the same as that of the insulating layer, or at least preferably closer to that of the insulating layer than it is to that of the first conductive material. If desired, the further material may be etched in step (e) at a slower rate than the insulating layer material. Photoresist is a particularly convenient material to use for the sacrificial further layer, especially for a thick layer, although other planarizing materials such as for example polyimide, and spun-on glass may be used instead.

Methods in accordance with the present invention may be employed with a wide variety of conductive and insulating materials for the electrical connection system, including multiple levels of interconnection with either the same or different materials at different levels. Tungsten and metal compositions based on tungsten are particularly efficient filler materials to fill the openings, even when the openings have sub-micron width. Silicon dioxide is a particularly convenient material for the insulating layer, both as regards the well-developed processing technologies for its growth or deposition and its definition and as regards its ease of reproduceable etching in forming the new upper surface in the etching treatment step (e). Therefore in a particularly convenient electrical connection system the first conductive material comprises tungsten, and the insulating layer comprises silicon dioxide at least adjacent the upper surface. The first conductive material may include a thin layer of another metal or alloy provided at least in the area of the opening before depositing the tungsten. This other metal layer may act as an adhesion layer for the tungsten in the openings or/and as a diffusion barrier layer or/and as a low contact resistance layer to the substructure. Titanium is a particularly convenient material for these purposes, especially with regard to its chemical bonding to oxygen, so that this thin layer preferably comprises titanium, for example as alloyed titanium silicide for contacting a silicon region in the substructure or for example as sputtered titanium-tungsten forming an intermediate adhesion layer.

In accordance with the present invention, the insulating layer thickness and depth of the openings in steps (a), (b) and (c) are larger than in the final structure. In many circuits in which the invention is used, the openings may have a width which is less than 1µm and less than the thickness of the insulating layer at least in steps (a), (b) and (c). In order to facilitate proper filling of small openings in step (b), even when using tungsten material, the depth of each opening in steps (a) and (b) is preferably less than 1.7 times its width. So as to ensure reliable elimination of large step-downs into small openings, the insulating layer material may be etched away in step (e) over a distance which is more than a quarter of the depth of at least one of the openings. However, it is often undesirable for this distance to be too large since otherwise insulation problems and/or parasitic capacitance problems may arise, or too large an initial layer thickness may be required. Therefore, this distance over which the insulating layer material is etched away in step (e) is preferably less than half the thickness of the insulating layer in steps (a), (b) and (c). In many circuits in which the invention is used, it may be preferable for the insulating layer in steps (a), (b) and (c) to be in excess of 1µm in thickness, having regard to these considerations.

These and other features in accordance with the invention are illustrated in specific embodiments of the invention now to be described, by way of example, with reference to the accompanying drawings, in which:
Figure 1 is a partly cross-sectional, partly perspective view of an insulating layer on a substructure at one stage in the manufacture of a semiconductor integrated circuit by a method in accordance with the invention,
Figures 2 to 5 are cross-sectional views of the part of the integrated circuit of Figure 1 at subsequent stages in its manufacture,
Figure 6 is a partly cross-sectional, partly perspective view of one example of a further stage in its manufacture,
Figure 7 is a cross-sectional view of one example of the layer structure shown around an enlarged view of plug 4B in Figures 2,3 and 5,
Figure 8 is a cross-sectional view of part of an integrated circuit having a multi-level interconnection system fabricated in accordance with the present invention, and
Figure 9 is a cross-sectional view of part of the circuit of Figure 8 illustrating one possible stage in its manufacture.

It should be noted that the Figures are diagrammatic and not drawn to scale. The relative dimensions and proportions of parts of these Figures (particularly in the direction of thickness) have been shown exaggerated or diminished for the sake of clarity and convenience in the drawings. The same (or related) reference signs as used in one embodiment are generally used for referring to corresponding or similar parts in other embodiments.

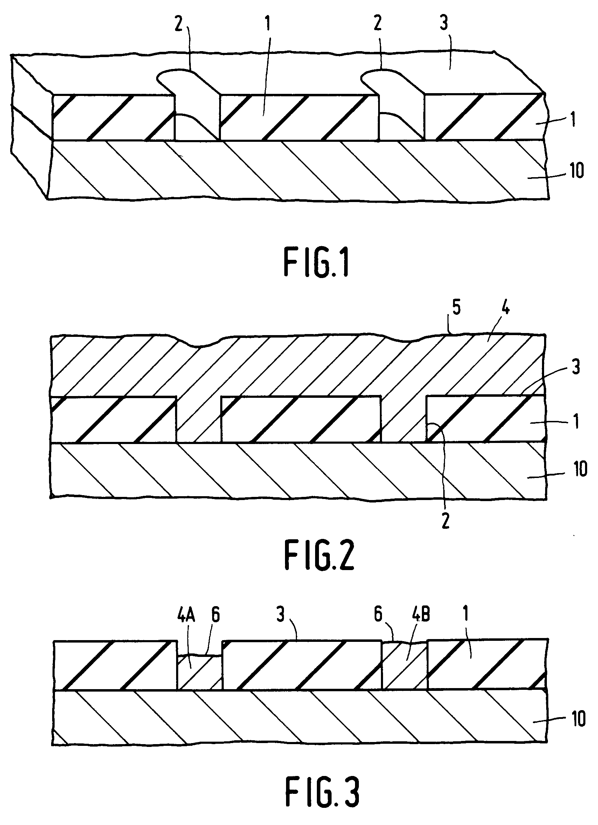

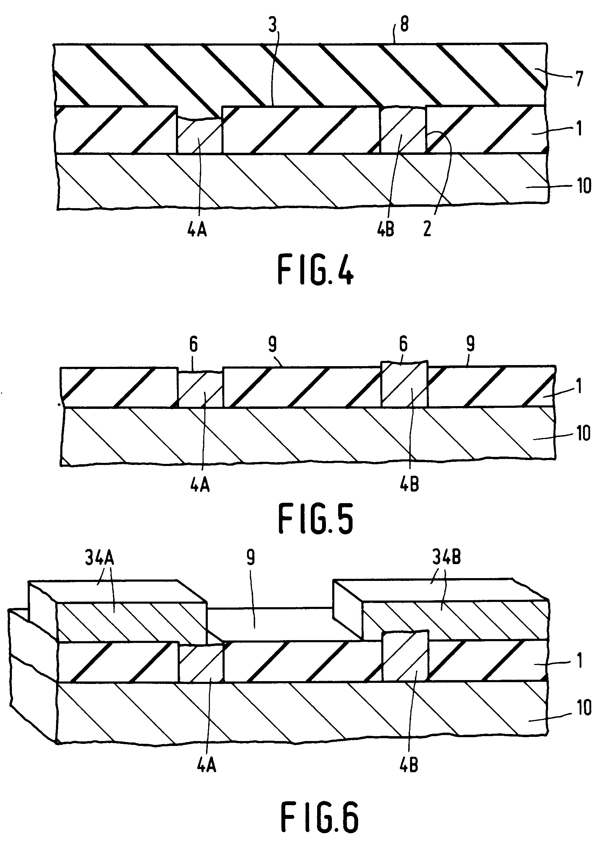

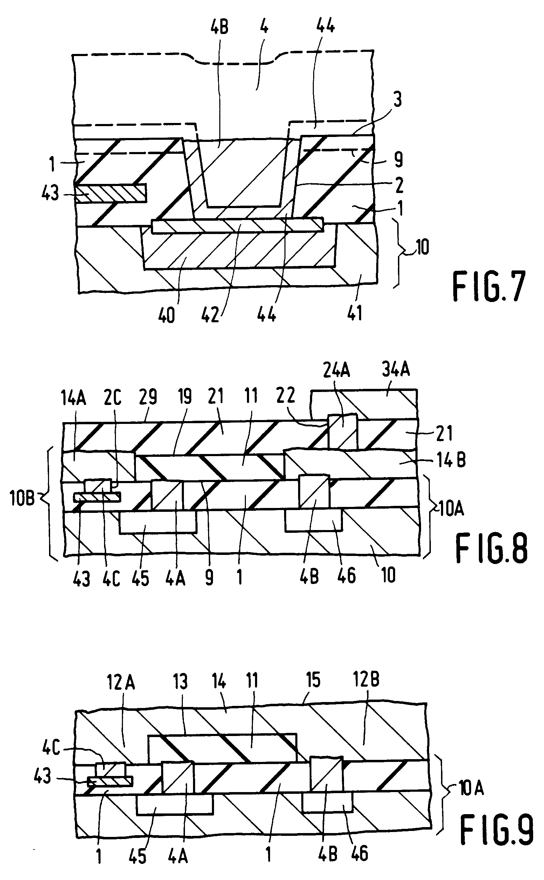

Figures 1 to 6 illustrate a specific method in accordance with the invention of manufacturing an integrated circuit using a method of fabricating electrical connections to a substructure 10 of the integrated circuit. This specific method includes the steps of:
(a) forming at a surface of the substructure 10 an electrically insulating layer 1 having openings 2 for the electrical connections, see Figure 1;
(b) depositing a first electrically conductive material 4 over the upper surface 3 of the insulating layer 1 and in the openings 2, to a thickness sufficient to form a largely planar upper surface 5 of the first conductive material 4, as illustrated in Figure 2;
(c) etching away the first conductive material 4 through a thickness sufficient to remove the first conductive material 4 from over the upper surface 3 of the insulating layer while leaving the first conductive material 4A,4B (Figure 3) in the openings 2, and
(d) thereafter depositing a second electrically conductive material (34 in Figure 6, or 14 in Figure 8) over the first conductive material 4A,4B and the upper surface of the insulating layer 1 to provide together with the first conductive material 4A,4B in the openings 2 at least part of the electrical connections of the integrated circuit.

In accordance with the present invention, between steps (c) and (d) there is performed at least a step of: (e) subjecting the upper surface 3 of the insulating layer 1 to an etching treatment which etches the insulating layer 1 at a rate faster than the first conductive material 4A,4B so as to form a new upper surface 9 of the insulating layer 1 (Figure 5) at a level which is lower than or substantially the same as the upper surfaces of the first conductive material 4A,4B in the openings 2 in the insulating layer 1. The deposition step (d) is then effected on this new surface 9.

The substructure 10 of Figure 1 may be, for example, a semiconductor substrate comprising doped zones of different conductivities and conductivity types which can be formed by dopant implantation and/or diffusion in known manner. These zones form part of circuit elements of the integrated circuit. Figure 7 illustrates one example of a particular form suitable for a silicon integrated circuit, in which a doped zone 40 is shown contacted by a metal electrode 4B, with an intermediate silicide layer 42 to reduce the contact resistance. The zone 40 may form a p-n junction with the adjacent part 41 of the silicon substrate and may be, for example, a source or drain zone of an MOS transistor having an insulated gate 43. The doped zones such as zone 40 can be formed in known manner by dopant implantation or/and diffusion in the silicon substrate 10. The titanium silicide layer is then formed in known manner on exposed silicon surface areas, after which an upper part of the insulating layer 1 may be deposited. In this way the insulating layer 1 may have embedded therein gates 43 of polycrystalline silicon or other conductive material. A VLSI circuit comprises many such MOS transistors and/or other circuit elements. Figures 8 and 9 show other doped zones 45 and 46 in the substructure 10, as well as illustrating the implementation of the invention on different substructures 10A and 10B.

At a surface of the substrate 10 the insulating layer 1 of Figure 1 is formed with contact openings 2. The layer 1 may comprise one or more insulating materials and may be formed in one or more steps. Thus, in the case of a silicon substrate 10, the layer 1 may comprise thermally grown silicon dioxide at least partly inset (not shown in the Figures) in the silicon substrate surface by local oxidation of the silicon. The openings 2 may be defined in this known manner by the local oxidation mask. However, the layer 1 may additionally or alternatively comprise deposited silicon dioxide or other insulating material (for example silicon nitride) grown in known manner by chemical vapour deposition, after which the openings 2 may be formed by a photolithographic and etching step. In the case of a VLSI circuit, the contact openings 2 may be of rounded (perhaps even, almost circular cross-section) with a width of micron or sub-micron size (i.e. about or less than 1 micrometre (µm) in diameter) and an aspect ratio of approximately unity (i.e. a ratio of depth to width of about one). The present invention may be used to fill openings 2 having a width less than the thickness of the insulating layer 1. In accordance with the present invention, the thickness of the insulating layer 1 and the depth of the openings 2 at the stage of Figure 1 are larger than desired for the final structure (Figure 6 or Figure 8). In one specific example, the contact openings 2 of Figure 1 may have a diameter of 0.9µm and a depth of 1.5µm. As illustrated in Figure 7, the walls of the openings 2 may slope slightly so that the width of the openings 2 may increase with height, for example from 0.9µm at the surface of the substrate 10 to about 1.2µm at the upper surface 3 of the insulating layer 1 having a thickness of 1.5µm.

Figure 2 illustrates the structure after the deposition step (b). Tungsten is advantageously chosen as the conductive material 4 since this material facilitates the filling of deep, sub-micron wide openings 2. The tungsten may be deposited in known manner, for example using the chemical vapour deposition system described in the previously mentioned Ellwanger et al conference paper. The deposition may be continued until the tungsten 4 has a thickness of, for example, 0.8µm or more above the surface 3 of the insulating layer 1 in the specific example with openings 2 of 0.9µm diameter and 1.5µm depth. In this specific example the variation in planarity of the tungsten surface 5 over the layer 1 and over the openings 2 is typically less than 0.2µm.

After this so-called "blanket" deposition of the tungsten, a blanket etch-back is effected in step (c) which produces the structure of Figure 3. This etch-back may be effected in known manner, for example using the plasma etch system described in the previously mentioned Ellwanger et al conference paper. In order to ensure complete removal of the tungsten 4 from the upper surface 3 of the insulating layer 1 (especially in a volume manufacturing process), it is advantageous to slightly prolong the etching treatment so that the remaining tungsten plugs 4A and 4B in the contact openings 2 are very slightly below the level of the surface 3, for example about 0.1µm or 0.2µm below. However, when effecting this, the applicants have found that in some of the openings 2 a significant upper part of the tungsten plug (e.g. for plug 4A in Figure 3) is removed. This appears to result from several factors of which the following appear to be significant at least at times: (a) inhomogeneity in the deposited tungsten material 4, (b) roughness of the deposited layer surface 5, (c) inhomogeneity in the etch-back process, and (d) local loading effects which are a much faster etch rate for local areas of tungsten (such as the plugs 4A surrounded by an insulating surface) than for a large surface area of tungsten where the openings are not yet exposed. In the specific example given above, when etching back 0.8µm or more of tungsten, step-down heights varying from about 0.1µm to 0.6µm have been observed in openings 2 of 0.9µm diameter and 1.5µm depth. Normally a step-down of about 0.1µm or even 0.2µm is acceptable. However such large step-downs of about 0.5µm or more into sub-micron openings 2 can cause step-coverage problems for the next layer of deposited material in the interconnection system of the integrated circuit, if that layer were to be directly deposited on the structure of Figure 3.

In accordance with the present invention this step-coverage problem is mitigated by effecting the etching step (e). In the form illustrated in Figures 4 and 5, a sacrificial planarizing layer 7 is first provided by depositing a further material (for example photoresist) over the upper surface 3 of the insulating layer 1 and over the first conductive material 4A,4B in the openings 2, to a thickness sufficient to form a largely planar upper surface 8 of the further material 7. This material 7 when subjected to the etching treatment of step (e) etches at a rate which is about the same as or at least much closer to that of the insulating layer 1 than it is to that of the first conductive material 4A,4B. Photoresist is a particularly convenient material which can be spun onto the Figure 3 structure in the usual mannerto provide a very flat surface 8, and plasma etching treatments for photoresist are well-developed having etching rates close to that for silicon dioxide. In the specific example given above, where the heights of the step-downs for tungsten plugs 4A and 4B in different openings 2 vary from 0.1µm to 0.6µm, the photoresist may be applied to a thickness of, for example, about 1µm or more, and its surface 8 may have no noticeable variation in planarity over the insulating layer 1 and the tungsten plugs 4A and 4B.

The Figure 4 structure is now subjected to the etching treatment of step (e) to etch away the planarizing material 7 and a surface part of the insulating material 1 to form a new upper surface 9 of the insulating layer 1 at a level which is substantially the same as or lower than the upper surfaces of the first conductive material 4A,4B in the openings 2, as illustrated in Figure 5. This may be effected using a known plasma etching treatment, for example with a plasma of CF₄, to which oxygen is also added for the etching of the photoresist 7. Using such an etching treatment (CF₄ and O₂, and then CF₄ alone) etching rates of about 10nm.s⁻¹ (nanometres per second) can be obtained for both the photoresist 7 and a silicon dioxide surface of layer 1; the etching rate is less than 1nm.s⁻¹ for tungsten plugs 4A and 4B. In the specific example given above, where step-downs of up to 0.6µm may be present, a thickness of about 0.5µm of silicon dioxide may be removed from the surface 3 of the insulating layer 1 to form the new surface 9. This removal of about 0.5µm is taken into consideration in determining the thickness of the insulating layer 1 originally provided, to ensure that an adequate thickness remains in Figure 5 (both above the substrate 10 and above any embedded gate 43) as to provide adequate insulation and reduction of, for example, parasitic capacitances. As a result of this thinning of the insulating layer 1, tungsten plugs 4A which had the maximum step-down in Figure 3 are now approximately coplanar with the insulating layer surface 9, whereas the other tungsten plugs 4B project as studs above the surface 9. Some of the plugs 4A may retain small step-downs, for example of 0.1µm or 0.2µm in the specific example given.

Figure 6 illustrates one example of a connection structure which can be formed from the Figure 5 structure, by depositing a layer of a second conductive material and then patterning it using photolithographic and etching steps to form conductor tracks 34A and 34B which adjoin respectively the tungsten plugs 4A and 4B. The conductor tracks 34A and 34B may be of, for example, aluminium which the applicants have found can be deposited adequately and reliably to cover step-ups of about 0.6µm at sub-micron wide tungsten studs 4B, whereas considerable difficulties were experienced in depositing aluminium over step-downs of 0.6µm from insulating layer surface 3 to tungsten plugs 4A. In a simple integrated circuit this conductive material 34 may form the top level of interconnection to a silicon circuit substrate 10. However, normally two or more levels of interconnection will be present on the substrate 10, an example of which is described with reference to Figure 8. Futhermore, although different materials (namely tungsten and aluminium) have so far been described for the layers 4 and 34 of Figure 6, it should be understood that the same metal or metal composition (capable of filling sub-micron wide openings 2) may be used for both the first and second conductive materials 4 and 34, if so desired. Furthermore, as illustrated in Figure 7, these materials may themselves be compound layers of different conductive materials.

Thus, Figure 7 illustrates one example of a multi-layer structure for contacting a doped zone 40 in a silicon substrate 41. A thin layer of, for example, titanium is sputter deposited over the surface of the insulating layer and on the exposed silicon surface areas, and the structure is then heated rapidly to form a titanium silicide contact layer 42 at the silicon surface areas. The remaining titanium on the insulating layer may be removed by etching in a solution of, for example, hydrogen peroxide and ammonium hydroxide in water. The sputter deposition, rapid thermal anneal and etching processes described in the Ellwanger et al conference paper may be used to form this silicide contact layer 42, after which the upper part of the insulating layer 1 is deposited and the openings 2 are formed.

Then, as the first part of the first conductive material 4, an adhesion layer 44 may be deposited on the insulating layer 1 and in the openings 2 to improve the adhesion of the subsequently-deposited tungsten to the insulating layer material. Such an adhesion layer 44 may be, for example, titanium or titanium-tungsten and may be sputter-deposited as described in the Ellwanger et al conference paper. Then, in the etching step (c), the etching treatment is such as to remove both the thick overlying tungsten layer and the titanium or titanium-tungsten layer 44 from over the surface 3 of the insulating layer 1. The SF₆ etch system described in the Ellwanger et al conference paper may be used. Both layers may be removed in one step, or the thick tungsten layer may be removed in one etching treatment and the underlying thin titanium or titanium-tungsten layer 44 may be removed in a separate subsequent treatment. The broken line 9 indicates the new surface to which the insulating layer 1 is thinned in the subsequent etching step (e).

Figure 8 illustrates a multi-level interconnection scheme formed from the basic structure of Figure 5 and also illustrates some other modifications which may be made. Thus, for example, the openings 2 in the insulating layer 1 which are filled with the first conductive material 4 need not extend through the entire thickness of the insulating layer 1 on the substrate 10. Opening 2c in Figure 8 extends through only the upper part of the insulating layer thickness for connection to the embedded gate layer 43. Thus, the substructure for contact opening 2c includes the gate layer 43 and the underlying part of the insulating layer 1. The opening 2c is formed in the same steps as the other openings 2 and is filled with a tungsten plug 4c in the same steps as the tungsten plugs 4A and 4B.

In the Figure 8 structure, the contact plugs 4A,4B,4C etc are contacted by conductor tracks of which only two are shown, namely tracks 14A and 14B. These tracks 14A,14B etc are connected by means of conductive plugs 24A etc in via openings 22 to an upper pattern of conductor tracks 34A etc. The steps (a) to (e) of the present invention may be used to fabricate the connections at these via openings 22, in which case the substructure 10B includes the underlying insulating layer and conductive layer structure 11,14,1,4 as well as the substrate 10; in this case the first conductive material is 24, the insulating layer is 21, its new etched-back surface is 29, and the second conductive material is 34. The conductor tracks 14A etc may be formed in the same manner as the tracks 34A and 34B of Figure 6 by deposition and photolithographic and etching steps, after which the insulating layer 11 may be deposited and then etched away from over the tracks 14A etc by using a planarising etching technique. However, the steps (a) to (e) of the present invention may even be used to fabricate the conductor tracks 14A,14B etc at openings 12A,12B etc in the insulating layer 11. This will now be described with reference to Figure 9.

Figure 9 illustrates an intermediate stage in the manufacture, in which an insulating layer 11 having openings 12A and 12B is present on the substructure 10A. In a specific example, the insulating layer 11 may have a thickness of about 1.5µm at this stage. The openings 12A and 12B differ from the rounded openings 2, in that these openings 12A and 12B are of elongate form having a width of about 1µm or less in one dimension (perpendicular to the plane of Figure 9) and a length of several µm in the longitudinal dimension (through which the cross-section of Figure 9 is taken). The blanket deposition of step (b) is effected to form a layer of first conductive material 14 over the upper surface 13 of the insulating layer 11 and in the openings 12A,12B. This material 14 may be, for example, about 1µm or more in thickness, and has a largely planar upper surface 15. Then, the etching step (c) is effected to remove the material 14 from over the surface 13 while leaving it as tracks 14A and 14B in the elongate openings 12A and 12B. Then, the etching step (e) is effected to etch back the insulating layer 11 and form a new upper surface 19 (see Figure 8) at a level which is lower than or substantially the same as the upper surfaces of the first conductive material forming the tracks 14A and 14B in the openings 12A and 12B. Subsequently, in step (d), a second conductive material is deposited to form the via connections 24A etc to the conductor tracks 14A and 14B.

It will be evident that many other modifications are possible. Thus, especially when a layer to be etched consists of various parts having different compositions, each etching step (c) and (e) may be performed in stages with different or modified etchants for the different compositions, or for example with a fast etchant for the initial etching stages followed by another or modified etchant which etches the same material slower and produces a smoother final surface. Although reference has been made mostly to plasma etching, it should be understood that other forms of dry etching as well as wet etching may be used. Thus, for example, reactive ion etching may be employed, or even ion milling which is essentially a sputter etch process with no chemical attack may be used. In using steps (a) to (e) of the present invention to fabricate the conductor tracks 14A,14B etc in elongate openings 12A,12B etc and via plugs 24A etc in via openings 22, it should be understood that adhesion-improvement layers such as layer 44 may advantageously be incorporated for both the tracks 14A,14B etc and plugs 24A etc, and the new surfaces 19 and 29 of the insulating layers 11 and 21 may be formed in an etching treatment which also involves etching away a sacrificial planarizing layer such as layer 7.

Methods in accordance with the invention are of particular benefit for semiconductor integrated circuits having contact and via openings of sub-micron width. Such circuits may be formed with substrates 10 of silicon or of, for example, gallium arsenide. However the invention may be employed in the manufacture of other integrated circuits, for example the circuit patterns integrated in a liquid-crystal display device or a surface-acoustic wave device or in some magnetic-bubble devices, which require electrical connections to a substructure. From reading the present disclosure, other modifications will be apparent to persons skilled in the art. Such modifications may involve other features which are already known in the design and manufacture of integrated circuits and other devices, their connection systems and other component parts thereof and which may be used instead of or in addition to features already described herein.

## Claims

1. A method of fabricating electrical connections to a substructure forming part of an integrated circuit, including the steps of: (a) forming at a surface of the substructure an electrically insulating layer having openings for the electrical connections, (b) depositing at least first electrically conductive material over the upper surface of the insulating layer and in the openings, the deposition being effected to a thickness sufficient to fill the openings and sufficient to provide for the first conductive material a largely planar upper surface which extends over both the insulating layer and the openings therein, (c) subjecting the planar upper surface to an etching treatment to etch back the first conductive material through a thickness sufficient to remove the first conductive material from over the upper surface of the insulating layer while leaving the first conductive material in the openings, and (d) thereafter depositing a second electrically conductive material over the first conductive material and the upper surface of the insulating layer to provide together with the first conductive material in the openings at least part of the electrical connections to the substructure, the method being characterised in that the insulating layer is formed in step (a) to a thickness larger than desired for the final structure, and in that after etching back the first conductive material in step (c) and before depositing the second conductive material in step (d), there is performed at least a step of: (e) subjecting the upper surface of the insulating layer to an etching treatment which etches the insulating layer at a rate faster than the first conductive material so as to form a new upper surface of the insulating layer at a level which is lower than or substantially the same as the upper surfaces of the first conductive material in the openings in the insulating layer.

2. A method as claimed in Claim 1, further characterised by performing between steps (c) and (e) at least a step of depositing a further material over the upper surface of the insulating layer and over the first conductive layer in the openings, to a thickness sufficient to form a largely planar upper surface of the further material, this further material being removed in step (e).

3. A method as claimed in Claim 2, further characterised in that the further material is etched away at a rate which is substantially the same as that of the insulating layer.

4. A method as claimed in Claim 2 or Claim 3, further characterised in that the further material is photoresist.

5. A method as claimed in any one of the preceding claims, further characterised in that the first conductive material comprises tungsten and the insulating layer comprises silicon dioxide at least adjacent to the upper surface.

6. A method as claimed in Claim 5, further characterised in that the deposition step (b) includes depositing a thin layer comprising titanium at least in the area of the openings before depositing the tungsten material.

7. A method as claimed in any one of the preceding claims, further characterised in that the openings have a width which is less than 1µm (micrometre) and less than the thickness of the insulating layer at least in steps (a), (b) and (c).

8. A method as claimed in any one of the preceding claims, further characterised in that the depth of each opening in steps (a) and (b) is less than 1.7 times its width.

9. A method as claimed in any one of the preceding claims, further characterised in that the insulating layer material is etched away in step (e) over a distance which is more than a quarter of the depth of at least one of the openings and less than half the thickness of the insulating layer in steps (a), (b) and (c).

10. A method as claimed in any one of the preceding claims, further characterised in that the insulating layer in steps (a), (b) and (c) is in excess of 1µm (micrometre) in thickness.

11. A method of manufacturing an integrated circuit wherein, after fabricating a substructure to form part of the circuit, electrical connections are fabricated to the substructure using a method claimed in any one of the preceding claims.

## Patentansprüche

1. Verfahren zum Herstellen elektrischer Verbindungen nach einer Unterstruktur als Teil einer integrierten Schaltung, wobei das Verfahren folgende Schritte umfaßt: (a) das Anbringen einer elektrisch isolierenden Schicht mit Öffnungen auf einer Oberfläche der Unterstruktur für die elektrischen Verbindungen, (b) das Ablagern wenigstens eines ersten elektrisch leitenden Materials auf der oberen Fläche der Isolierschicht und in den Öffnungen, wobei der Niederschlag bis zu einer ausreichenden Dicke zum Ausfüllen der Öffnungen und ausreichend zum Anbringen einer weitgehend planaren oberen Fläche für das erste Leitmaterial durchgeführt wird, wobei diese obere Fläche sich sowohl Über die Isolierschicht als auch über die darin befindlichen Öffnungen erstreckt, (c) das Durchführen einer Ätzbehandlung an der planaren oberen Fläche zum Rückätzen des ersten Leitmaterials durch eine ausreichende Dicke zum Entfernen des ersten Leitmaterials über die obere Fläche der Isolierschicht, während das erste Leitmaterial in den Öffnungen zurückbleibt, und (d) anschließend das Niederschlagen eines zweiten elektrisch leitenden Materials auf dem ersten Leitmaterial und auf der oberen Fläche der Isolierschicht, um zusammen mit dem ersten Leitmaterial in den Öffnungen wenigstens teilweise die elektrischen Verbindungen nach der Unterstruktur anzubringen, dadurch gekennzeichnet, daß die Isolierschicht im Schritt (a) zu einer größeren Dicke als der gewünschten Dicke für die Endstruktur gebildet wird, und daß nach dem Rückätzen des ersten Leitmaterials im Schritt (c) und vor dem Ablagern des zweiten Leitmaterials im Schritt (d) wenigstens ein folgender Schritt ausgeführt wird: (e) das Durchführen einer Ätzbehandlung an der oberen Fläche der Isolierschicht, wobei die Isolierschicht mit einer Geschwindigkeit höher als die beim ersten Leitmaterial geätzt wird, um eine neue obere Fläche der Isolierschicht auf einem Pegel zu bilden, der niedriger ist als oder im wesentlichen gleich den oberen Flächen des ersten Leitmaterials in den Öffnungen in der Isolierschicht.

2. Verfahren nach Anspruch 1, dadurch gekennzeichnet, daß zwischen den Schritten (c) und (e) wenigstens ein Niederschlagsschritt für ein weiteres Material auf der oberen Flache der Isolierschicht und auf der ersten Leitschicht in den Öffnungen bis zu einer ausreichenden Dicke durchgeführt wird, um eine weitgehend planare obere Fläche des weiteren Materials zu bilden, wobei dieses weitere Material im Schritt (e) entfernt wird.

3. Verfahren nach Anspruch 2, dadurch gekennzeichnet, daß das weitere Material mit einer Geschwindigkeit abgeätzt wird, die im wesentlichen gleich der der Isolierschicht ist.

4. Verfahren nach Anspruch 2 oder 3, dadurch gekennzeichnet, daß das weitere Material Photoresist ist.

5. Verfahren nach einem oder mehreren der vorangehenden Ansprüche, dadurch gekennzeichnet, daß das erste Leitmaterial Wolfram und die Isolierschicht Siliziumdioxid wenigstens neben der oberen Fläche enthält.

6. Verfahren nach Anspruch 5, dadurch gekennzeichnet, daß der Niederschlagsschritt (b) das Ablagern einer dünnen Schicht mit Titan wenigstens im Bereich der Öffnungen vor dem Ablagern des Wolframmaterials umfaßt.

7. Verfahren nach einem oder mehreren der vorangehenden Ansprüche, dadurch gekennzeichnet, daß die Öffnungen eine Breite haben, die weniger als 1 µm und kleiner als die Dicke der Isolierschicht wenigstens in den Schritten (a), (b) und (c) ist.

8. Verfahren nach einem oder mehreren der vorangehenden Ansprüche, dadurch gekennzeichnet, daß die Tiefe jeder Öffnung in den Schritten (a) und (b) kleiner als das 1,7-Fache ihrer Breite ist.

9. Verfahren nach einem oder mehreren der vorangehenden Ansprüche, dadurch gekennzeichnet, daß das Iolierschichtmaterial im Schritt (e) über eine Strecke weggeätzt wird, die großer als ein Viertel der Tiefe wenigstens einer der Öffnungen und geringer als die halbe Dicke der Isolierschicht in den Schritten (a), (b) und (c) ist.

10. Verfahren nach einem oder mehreren der vorangehenden Ansprüche, dadurch gekennzeichnet, daß die Isolierschicht in den Schritten (a), (b) und (c) eine größere Dicke hat als 1 µm.

11. Verfahren zum Herstellen einer integrierten Schaltung, worin nach dem Herstellen einer Unterstruktur zur Bildung eines Teils der Schaltung elektrische Verbindungen nach der Unterstruktur unter Verwendung eines Verfahrens nach einem oder mehreren der vorangehenden Ansprüche hergestellt werden.

## Revendications

1. Procédé de fabrication de liaisons électriques à une sous-structure faisant partie d'un circuit intégré, comportant les étapes (a) de formation, sur une surface de la sous-structure, d'une couche électriquement isolante présentant des ouvertures pour les liaisons électriques, (b) de dépôt d'au moins un premier matériau électriquement conducteur sur la surface supérieure de la couche isolante et dans les ouvertures, le dépôt étant effectué jusqu'à une épaisseur suffisante pour remplir les ouvertures et pour fournir au premier matériau conducteur une surface supérieure sensiblement plane s'étendant à la fois sur la couche isolante et les ouvertures pratiquées dans celle-ci, (c) de traitement par attaque de la surface supérieure plane pour enlever le premier matériau conducteur sur une épaisseur suffisante pour éliminer le premier matériau conducteur de la surface supérieure de la couche isolante tout en laissant subsister le premier matériau conducteur dans les ouvertures et, ensuite, (d) de dépôt d'un second matériau électriquement conducteur sur le premier matériau conducteur et la surface supérieure de la couche isolante de façon à créer, conjointement avec le premier matériau conducteur contenu dans les ouvertures, au moins une partie des liaisons électriques à la sous-structure, caractérisé en ce que, dans l'étape (a), la couche isolante est formée jusqu'à une épaisseur supérieure à celle souhaitée pour la structure finale, et en ce que, après l'enlèvement partiel par attaque du premier matériau conducteur dans l'étape (c) et avant le dépôt du second matériau conducteur dans l'étape (d), on procède au moins à l'étape (e) consistant à soumettre la surface supérieure de la couche isolante à un traitement d'attaque ayant pour effet d'attaquer la couche isolante à une vitesse plus grande que le premier matériau conducteur de façon à former une nouvelle surface supérieure de la couche isolante, à un niveau inférieur ou sensiblement égal à celui des surfaces supérieures du premier matériau semiconducteur contenu dans les ouvertures de la couche isolante.

2. Procédé selon la revendication 1, encore caractérisé en ce qu'entre les étapes (c) et (e), on effectue au moins une étape de dépôt d'un autre matériau sur la surface supérieure de la couche isolante et sur la première couche conductrice située dans les ouvertures, jusqu'à une épaisseur suffisante pour former une surface supérieure sensiblement plane de l'autre matériau, cet autre matériau étant éliminé dans l'étape (e).

3. Procédé selon la revendication 2, encore caractérisé en ce que l'autre matériau est attaqué à une vitesse sensiblement identique à celle de la couche isolante.

4. Procédé selon la revendication 2 ou 3, encore caractérisé en ce que l'autre matériau est du photorésist.

5. Procédé selon l'une quelconque des revendications précédentes, encore caractérisé en ce que le premier matériau conducteur comporte du tungstène et en ce que la couche isolante comporte du bioxyde de silicium au moins à proximité de la surface supérieure.

6. Procédé selon la revendication 5, encore caractérisé en ce que l'étape de dépôt (b) comporte le dépôt d'une couche mince comportant du titane, au moins à l'endroit des ouvertures avant le dépôt du tungstène.

7. Procédé selon l'une quelconque des revendications précédentes, encore caractérisé en ce que les ouvertures ont une largeur inférieure à 1 µm (micromètre) et inférieure à l'épaisseur de la couche isolante au moins dans les étapes (a), (b) et (c).

8. Procédé selon l'une quelconque des revendications précédentes, encore caractérisé en ce que la profondeur de chaque ouverture, dans les étapes (a) et (b), est inférieure à 1,7 fois sa largeur.

9. Procédé selon l'une quelconque des revendications précédentes, encore caractérisé en ce que le matériau de la couche isolante est enlevé, dans l'étape (e), sur une distance supérieure au quart de la profondeur d'au moins l'une des ouvertures et inférieure à la moitié de l'épaisseur de la couche isolante dans les étapes (a), (b) et (c).

10. Procédé selon l'une quelconque des revendications précédentes, encore caractérisé en ce que la couche isolante, dans les étapes (a), (b) et (c), a une épaisseur supérieure à 1 µm (micromètre).

11. Procédé de fabrication d'un circuit intégré, suivant lequel, après la réalisation d'une sous-structure pour former une partie du circuit, on établit des liaisons électriques à la sous-structure par la mise en oeuvre d'un procédé selon l'une quelconque des revendications précédentes.
